# EUROPEAN PATENT APPLICATION

(11) **EP 1 115 151 A1**
(43) Date of publication of application: **11.07.2001**
(21) Application number: 99933154.9
(22) Date of filing: 29.07.1999
(51) Int. Cl.: H01L 23/02, H01L 23/04, H01L 25/04

(54) **FLAT SEMICONDUCTOR DEVICE, METHOD FOR MANUFACTURING THE SAME, AND CONVERTER COMPRISING THE SAME**

(30) Priority: 07.08.1998 JP 22403098; 17.08.1998 JP 23044898
(71) Applicant: Hitachi, Ltd., Chiyoda-ku, Tokyo 101-8010 (JP)
(72) Inventor: KODAMA, Hironori, Hitachi-shi, Ibaraki 319-1292 (JP); SUZUKI, Kazuhiro, Hitachi-shi, Ibaraki 319-1292 (JP); WATANABE, Atsuo, Hitachi-shi, Ibaraki 319-1292 (JP); KATO, Shuji, Hitachi-shi, Ibaraki 319-1292 (JP); SONOBE, Yukio, Hitachi-shi, Ibaraki 319-1292 (JP); KATO, Mitsuo, Hitachi-shi, Ibaraki 319-1292 (JP); SAWAHATA, Mamoru, Hitachi-shi, Ibaraki 319-1292 (JP); HASEGAWA, Mitsuru, Hitachi-shi, Ibaraki 319-1292 (JP)
(74) Representative: Strehl Schübel-Hopf & Partner
(86) International application number: JP9904072
(87) International publication number: WO0008683

(57) **Abstract**

In a flat type semiconductor device containing at least one semiconductor element in a flat type package in which an insulating outer cylinder insulates and seals between a pair of common main electrode plates exposing to both surfaces of the flat type semiconductor device, the semiconductor element haing a first main electrode on a first main surface and a second main electrode on a second main surface, at least a part of the insulating outer cylinder is formed of a resin part, or an outer peripheral portion not facing an intermediate electrode plates among surfaces of the semiconductor element and at least part of side surface of the intermediate electrode plate are sealed by an electric insulation material.

## Description

### BACKGROUND OF THE INVENTION

The present invention relates to a flat type semiconductor device, and particularly to a flat type semiconductor device which can economically secure high insulation reliability by realizing a hermetic seal structure between electrodes connected to a contained semiconductor element, and to a converter using the flat type semiconductor device.

The power electronics technology for controlling. main circuit current by making full use of semiconductor electronics technology has been widely applied to various fields, and further the application is being expanded. As the power semiconductor elements, there are a thyristor, a photo-thyritor, a GTO (gate turn-off) thyristor, a GCT (gate commutated turn-off) thyristor, an insulated gate bipolar transistor (hereinafter, referred to as IGBT) of a MOS control device, a MOS field-effect transistor (hereinafter, referred to as FET) and so on. In the devices of these types, in general, one main electrode (cathode, emitter electrode) is formed on the first main surface of a semiconductor chip and the other main electrode (anode, collector electrode) is formed on the second main surface.

In a large power semiconductor device such as the GTO, the optical thyristor and the like, the elements are packaged wafer by wafer. The both main electrodes of the element are constructed so as to be pressed by and contact with a pair of external main electrodes of a package through thermal buffer electrode plates made of molybdenum or tungsten, and are generally of a flat structure which is suitable for being pressed.

On the other hand, in the IGBT and the like, a plurality of chips are mainly mounted in a package form of electrode connection using wires which is called as a module type structure. In the case of the module type package, since heat generated inside the element is dissipated only from one side surface of the package, that is, from the collector side directly mounted on a metal base, the thermal resistance is large and accordingly number of chips. (amount of heat generation or current capacity) capable of being mounted on one package is limited. In recent years, in order to solve such a problem and satisfy the need of large capacity, considerable attention is attracted to a flat type semiconductor device of a parallel multi-chip type pressurizing-contact structure in which a plurality of IGBT elements are integrated in parallel in a flat package similar to the package for the GTO, the optical thyristor or the like described above, and the emitter electrode and the collector electrode are individually face-contacted with and led out by a pair of external main electrode plates provided in the package. Compared to the conventional module type package, the flat type package structure can be expected to improve in the points 1) that the reliability of connection can be improved because the connection of the main electrode is not wire bonding, and 2) that the inductance and the resistance of the connecting conductor can be reduced, and 3) that the cooling efficiency can be improved because the semiconductor chip can be cooled from the both sides.

The conventional flat type semiconductor device is formed to hermetically seal the inside of the package (a hermetic seal structure) in order to protect a contained semiconductor element, not shown, as. shown in FIG. 14, which is disclosed, for example, in Japanese Patent Application Laid-Open No.7-66228, Japanese Patent Application Laid-Open No.7-254669, Japanese Patent Application Laid-Open No.8-330338. In more detail, outer main electrode plates 4, 5 are gas-tightly bonded to a ceramic parts 31 through metal flanges..32, 33 to form a structure of hermetically sealing the inside. The anti-humidity reliability of the flat type semiconductor device is secured by the hermetic seal structure, but there are a problem in that cost of the parts themselves complying with hermetic seal and working cost of the hermetic seal are high.

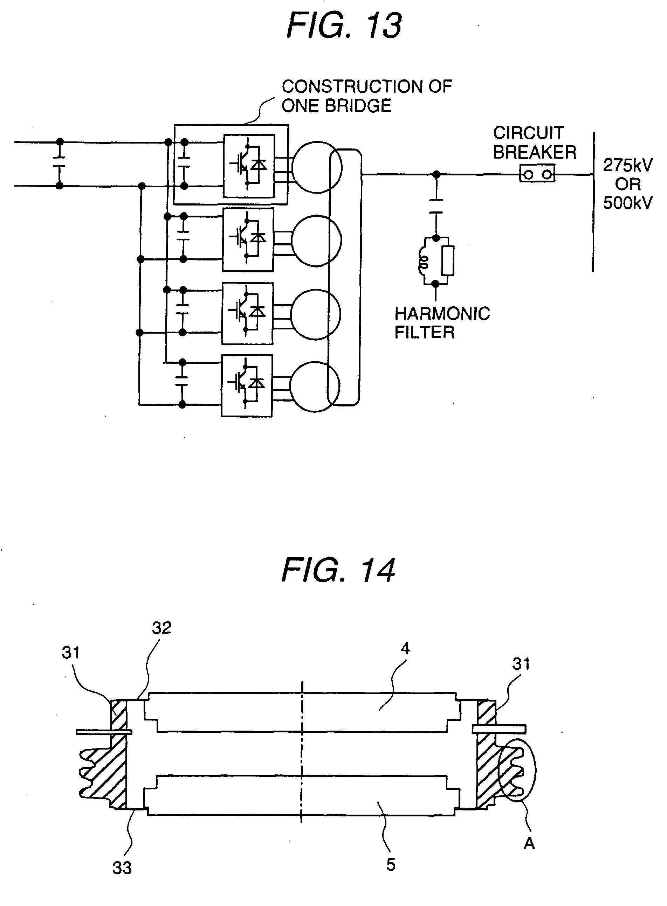

Further, in the semiconductor device, it is necessary to secure a distance along the external surface of the package longer than a required length corresponding to the withstand voltage of the element in order to guarantee the long-term insulation in the outside of the package. Therefore, the distance along the external surface is usually increased by shaping the outer portion (portion A in FIG. 14) of the outer cylinder 31 made of ceramic into a complicated shape. However, since ceramic is generally very hard and a material of difficult-to-machining, the cost of forming the ceramic into the complicated shape as described above is high. This is a large factor to increase cost of the package.

Since withstand voltage of semiconductor elements is in a tendency to increase higher, and particularly the flat type semiconductor device is strongly required to increase its capacity, a tendency of high withstand voltage of elements gradually becomes dominant. In the package of the module type structure, in order to secure insulation between the heat sink exposed outside the package and the element (insulating performance to ground), and to cope with the problem of discharge between wires contained inside the package, and to make size of the package compact, the insulation reliability is secured by filling the inside of the package with a gel. On the other hand, in the element of the flat type structure, so far today, the insulation between the main electrode has been cope with by securing a spatial distance because it is sufficient to secure the insulation only at OFF-state. However, as the withstand voltage of elements is higher in the future, it is becoming a very difficult problem to secure the withstand voltage (prevent discharge) around the semiconductor elements including the containing structure and to secure the insulation reliability.

Furthermore, in the flat type semiconductor device of the type mounting a plurality of chips in parallel, frame parts are used for positioning the individual chips as disclosed, for example, in Japanese Patent Application Laid-Open No.7-94673 and Fuji Jihou (Fuji Current. News), Vol.69, No.5 (1996), but the mounting density. is reduced by the volume of the parts. In order to make the size of the flat type semiconductor device as small as possible and to make the converting capacity larger, it is necessary to further increase the mounting density of the semiconductor device. Further, the specific parts for positioning are additionally required to increase number of parts, which is also a problem to be solved from the view points of assembling workability, cost of the parts and so on.

### SUMMARY OF THE INVENTION

The present invention is made in order to solve the above problems, and an object of the present invention is to provide a means for securing the insulation reliability of a flat type semiconductor device. Further, another object of the present invention is to provide a high reliable large capacity converter.

In a flat type semiconductor device in accordance with the present invention, an insulating outer cylinder insulates and seals between a pair of common main electrode plates exposing to both surfaces of the flat type semiconductor device, and at least a part of the insulating outer cylinder is formed of a resin part. Particularly, in a case where hermetic seal is inevitable, a composite insulation cylinder composed of a closely packed. insulator part made of an inorganic material and a resin part is used for the insulation outer cylinder described above, and the flat type semiconductor device is hermetically sealed by the closely packed insulator part made of an inorganic material and the sufficient distance along the external surface is . secured by the resin part. That is, by separating a function of a material for hermetically sealing from a function of a material for sufficiently securing the distance along the insulating distance (the distance along the surface), both of high long term reliability and low cost can be attained. That is, the cost can be reduced by forming the complicated shaped part using the resin part easy in machining and in molding to sufficiently secure the external insulation distance of the semiconductor device.

Another semiconductor device in accordance with the present invention is a flat type semiconductor device containing at least one semiconductor element in a flat type package in which an insulating outer cylinder insulates externally between a pair of common main electrode plates exposing to both surfaces of the flat type semiconductor device, the semiconductor element having a first main electrode on a first main surface and a second main electrode on a second main surface, wherein an assembling structure (a chip carrier structure) of the semiconductor element and intermediate electrode plates is used, and the assembling structure is that the individual. intermediate electrode plates are inserted into gaps between two main electrodes of the semiconductor element and the main electrode plates respectively opposite to the main electrodes for each of the semiconductor elements, and an outer peripheral portion not facing the intermediate electrode plates among surfaces of the semiconductor element. and at least part of side surface of the intermediate electrode plate are sealed. by an electric insulation material.

Further, the electric insulation outer cylinder for insulating and sealing between the pair of main electrode plates exposing to the both surfaces is formed of a resin part, and is formed in a non-hermetic structure. Thereby, the cost can be further reduced.

### BRIEF DESCRIPTION OF DRAWINGS

FIG. 1 is a view showing an embodiment of the present invention which applied to an IGBT element.

FIG. 2 is a view showing an embodiment of the present invention which applied to a GTO element.

FIG. 3 is a view showing an embodiment of outer cylinder parts of a divide type made of resin (a), and an enlarged view showing a coupling portion of the outer cylinder parts of the divide type made of resin (b).

FIG. 4 is views showing an outer cylinder part totally made of resin and the mounting embodiment (a), an outer cylinder part totally made of resin and the mounting embodiment (b), and an outer cylinder part totally made of resin and the mounting embodiment (c).

FIG. 5 is a view showing an embodiment of the present invention.

FIG. 6 is a view showing another embodiment of the present invention.

FIG. 7 is views showing other embodiments in accordance with the present invention.

FIG. 8 is a view showing another embodiment in accordance with the present invention.

FIG. 9 is views showing other embodiments in accordance with the present invention.

FIG. 10 is views showing other embodiments in accordance with the present invention each of which has a control terminal.

FIG. 11 is a view showing an outer cylinder part totally made of resin and the mounting embodiment.

FIG. 12 is a diagram showing a circuit of one bridge portion using the semiconductor device in accordance with the present invention.

FIG. 13 is a diagram showing a self-exited converter which has a quadrupled construction of the three-phase bridges of FIG. 12.

FIG. 14 is a view showing a conventional flat type semiconductor device.

### DESCRIPTION OF THE PREFERRED EMBODIMENTS

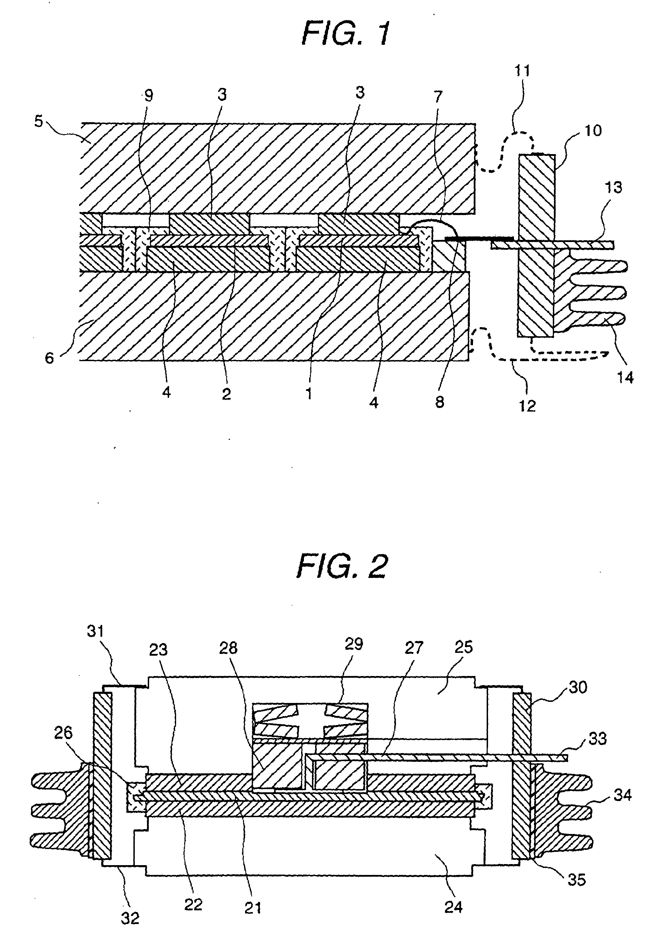

FIG. 1 shows an example of a reverse conducting type switching device to which the present invention is applied, the reverse conducting type switching device containing switching devices using IGBTs and anti-parallel connected flywheel diodes (FWD). The figure shows only part of the section of the flat type semiconductor device from the outermost periphery to a middle portion toward the center. In the IGBT chip 1, an emitter electrode is formed on nearly the whole surface of a first main surface in the upper surface side, and a collector electrode is formed on a second main surface in the lower surface side. Further, a control electrode (a gate electrode) is formed on the first main surface. In the FWD chip 2, an anode electrode is formed on the upper surface side of a silicon substrate, and a cathode electrode is formed on the lower surface side. In each of the semiconductor chips, intermediate electrodes 3, 4 made of molybdenum for serving heat dissipation and electric connection are individually fixed to and contacted with the main electrodes on the chip, and each of the chips in contact with the intermediate electrodes is further put between a first common main electrode plate 5 (Cu) and a second common main electrode plate 6 (Cu). A wire is led out using a wire bond 7 from a gate electrode of the IGBT chip 1, and is further connected to a gate electrode wire 8 formed on the common main electrode 6. The semiconductor chip and the intermediate electrodes described above are fixed to each other using a frame 9 made of Teflon. An electric insulation outer cylinder 10 made of aluminum ceramic externally insulates between the pair of common main electrode plates 5 and 6 described above, and metal flanges 11, 12 connect between the common main electrode plates 5, 6 and the insulator outer cylinder 10 to form a hermetic structure of sealing the inside of the package. The gate electrode wire is led outside the package by a sealed wire 13 penetrating through the outer cylinder 10. In the present embodiment, a mold is set to the ceramic outer cylinder 10 after hermetically sealing the contained elements, and then after potting silicone rubber into the mold, the silicone rubber is cured at 150 °C to form a resin outer cylinder part 14 onto the ceramic outer cylinder 10 in a one-piece structure.

The distance along surface could be easily made very larger by making projections and depressions in the outer portion larger compared to a conventional ceramic part, as shown in the figure. It was also checked from an accelerated endurance test that the semiconductor device had sufficient reliability.

FIG. 2 shows an embodiment of the present invention which applied to a GTO element. A semiconductor element 21 is constructed by one silicon wafer, and has at least one p-n junction inside. In the semiconductor element 21, a cathode electrode and a gate electrode made of aluminum (Al) are formed on one main surface, and an anode electrode made of aluminum (Al) is formed on the other main surface. Further, intermediate electrode plates 22 and 23 made of molybdenum (Mo) are arranged. Furthermore, the whole of the semiconductor element 21 and the intermediate electrode plates 22 and 23 are pressed outside of the intermediate electrode plates 22 and 23 using a pair of outer main electrode plates 24 and 25 made of copper (Cu). A cap member 26 is arranged in the side surface of the semiconductor element 21. Part of a gate lead 27 is arranged so as to be in contact with the gate electrode on the semiconductor substrate, and part of the gate lead is press contacted to the gate electrode with a gate insulator 28 and a dish spring 29.

All the portions described above are arranged inside a hermetic sealed package surrounded by a ceramic insulator 30, the pair of outer electrodes 24, 25 and flanges 31, 32. The other end portion of the gate lead 27 is led outside the insulator 30 through the sealing structure as a gate terminal 33.

An outer cylindrical ring 34 made of polyphenylene sulfide resin (having a tracking resistance above 600 V) pre-molded through injection molding is bonded to the ceramic outer cylinder 30 with silicone bond 35. By ding so, the external distance along surface could be sufficiently secured above a specified value, and it was also checked from an accelerated endurance test that the semiconductor device had sufficient reliability.

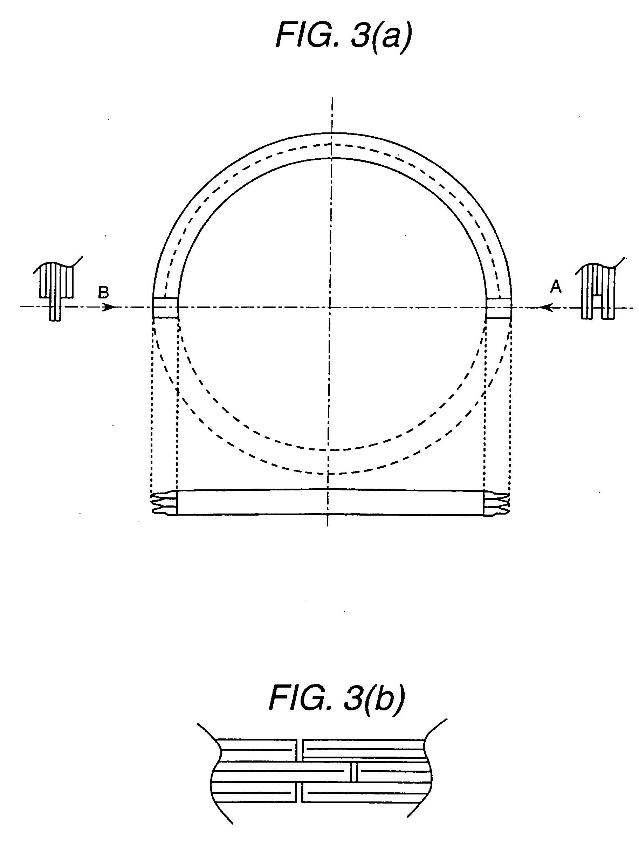

FIG. 3a shows an example of the outer cylindrical ring made of resin described above which has a two-divided structure. The divided parts are formed so as to be coupled and engaged at their ends with each other. Number of divisions is not limited to two parts as in the present example, but the outer cylindrical ring may be divided into any number of parts so as to be easily assembled corresponding to shape of the ceramic outer cylindrical part to be combined.

FIG. 3b is an enlarged view showing a coupling portion (the engaged portion) in a state of coupling the two parts of FIG. 3a.

In the complex insulation outer cylinder of the insulation outer cylindrical part made of ceramic or the like and the resin part described above, the complex insulation outer cylinder may be formed before mounting the element, or after mounting the element into and sealing the insulation outer cylindrical part, the resin portion may be formed through potting or fitting/bonding, as in the embodiment described above. Further, of course, the resin part may be formed so as to cover over all the surface of the ceramic part. Such a structure is preferable because it has an effect to prevent the ceramic part from being broken or chipped due to an impact at handling.

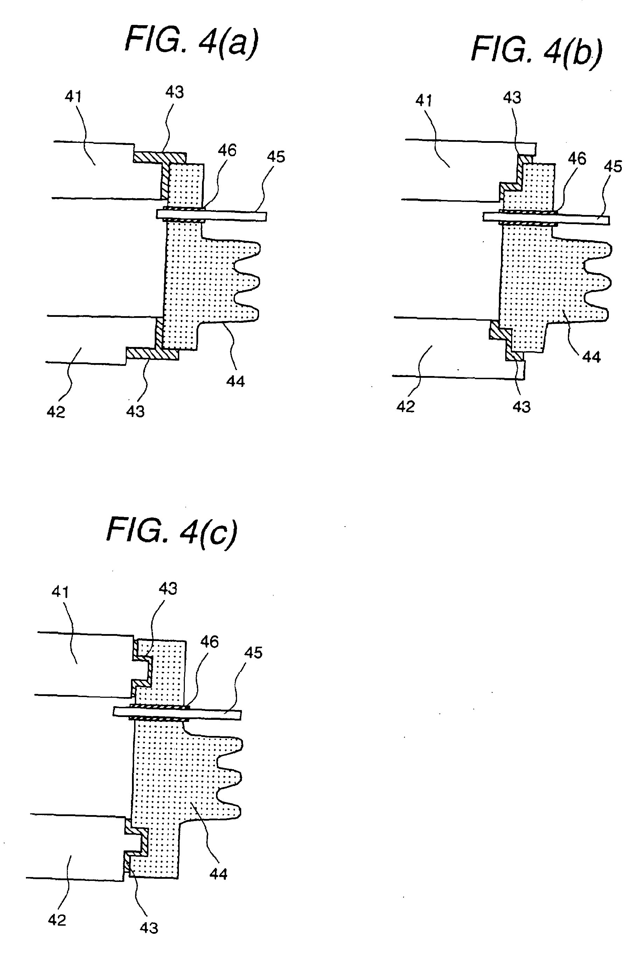

FIG. 4 shows examples of the insulation outer cylinders which are totally made of resin. FIG. 4a shows the example in which the pair of outer main electrode plates 41, 42 are externally insulated between them and sealed by an outer cylinder 44 made of aromatic polyamide. The outer main electrode plates 41, 42 are bonded to the insulation outer cylinder 44 with an organic bond 43 to form a sealing structure. Further, a metallic wire 45 fixed with a bond 46 is formed in the insulation outer cylinder 44, and by the wire the gate electrode wire is led outside the package. FIG. 4b shows a similar example in which the sealing structure between the outer main electrode plates 41, 42 and the insulation outer cylinder 44 is modified. This structure is preferable because the bonded portion is always pressed in the direction strengthening the sealing when the semiconductor device is pressed while being used. : Further, the sealing structure of FIG. 4c is particularly preferable because part of the bond is always pressed in the direction to secure the sealing when the gap between the outer main electrode plates 41, 42 is expanded and when the gap is contracted. It is preferable that a bond having a large elastic deformativity is used for the bond because it can respond to change in the distance between the main electrodes at being pressed and to deformation during being used.

As a characteristic required for the resin group material, it is preferable that the tracking resistance (CTI value) is higher than 400 V, particularly preferable higher than 600 V. It is also preferable to use a resin material which has a flame retardancy of UL94V-0 level. Further, in regard to the thermal and mechanical properties, it is also preferable to use a resin material which is high in mechanical strength and in brittle rupture strength, and of which the thermal expansion coefficient can be adjusted to an optimum value determined by the other mounting materials and the mounting structure. In the case where the resin part is combined and integrated with the electric insulation outer cylindrical part made of ceramic or the like, the resin material has a thermal expansion coefficient as near that of the ceramic group part as possible. As the concrete materials, it is preferable to use a thermosetting resin of epoxy group, phenol group or the like, or an elastomer of silicone group, fluoride group. Further, a thermoplastic resin of engineering plastic group such as polyphnylene sulfide (PPS), aromatic polyamide, thermoplastic polyimide or the like may be used. Furthermore, a composite material mixing various kinds of filler to these material may be used. Since the insulation outer cylinder is a resin part, the shape along the external surface can be comparatively freely designed compared to the conventional ceramic part. Therefore, there is an advantage in that limitation in the design for securing the distance along external surface can be reduced.

As the method of manufacturing the resin part, in addition to the potting method described in the above example, injection molding, transfer molding, compression molding, powder sintering methods may be used, and an optimum method may be selected depending on the material and the mounting method.

Particularly, in the case where the resin part is molded to be integrated directly with the ceramic outer cylinder through potting method, it is preferable to use silicone resin, urethane resin, polystyrene resin, polybutadiene resin, or an elastomer composed of copolymer of these resins, or a thermosetting material such as epoxy resin, phenol resin. In the case where the pre-molded. resin part is bonded to be integrated with the electric insulation outer cylinder part or the electrode material made of ceramics or the like, it is preferable to. use a silicone group, a fluoride group or an epoxy group rubber because the stress between materials to be bonded can be released by the rubber.

As the materials of the electric insulation part used for hermetically sealing, it is preferable to use an ordinary porcelain such as feldspathic ordinary porcelain, cristobalite porcelain, alumina containing porcelain, alumina containing cristobalite porcelain or the like, or a material containing a major component of alumina, magnesia, beryllia, steatite, forsterite, cordierite, mullite, zircon, zirconia or the like, or a glass group material such as a glass ceramic, boro-silicate glass, quartz glass, high silicate glass or the like. In the case where the electric insulation outer part made of the above-mentioned inorganic material is bonded to the resin part, it is a method effective to increase the bonding strength with the resin part by forming the surface of the inorganic material electric insulation outer part in an uneven surface. In order to do so, it is effective that unevenness is intentionally formed. on the surface by controlling the sintering condition of the inorganic material electric insulation outer part, or that the inorganic material electric insulation outer part is normally sintered, and then the surface is processed using a means such as sandblast, liquid horning, etching, chemical grinding, electro-grinding or the like.

The method of the present invention can be applied to both of a flat type semiconductor device in which many semiconductor chips are arranged in parallel and contained between a pair of main electrode plates, and a flat type semiconductor device in which semiconductor element is formed of one sheet of semiconductor element wafer having at least one p-n junction. Further, in addition to a flat type semiconductor device composed of a switching semiconductors such as IGBTs or the like not including any diode, it is also effective that many diode chips only, for example, can be mounted in a flat type package. The present invention relates to all kinds of the semiconductor elements that have at least a first main electrode on the first main surface and a second main electrode on the second main surface, and is effective in applying to an insulated gate transistor (MOS transistor) other than the IGBT; to a semiconductor element with a control electrode such as an insulated gate thyristor (MOS controlled thyristor). including an IGCT (insulated gate controlled thyristor), a GTO thyristor, a GCT thyristor, an optical thyristor, a thyristor; and to a diode. Similarly, the present invention is effective in applying to a chemical compound semiconductor element such as SiC, GaN in addition to the Si element.

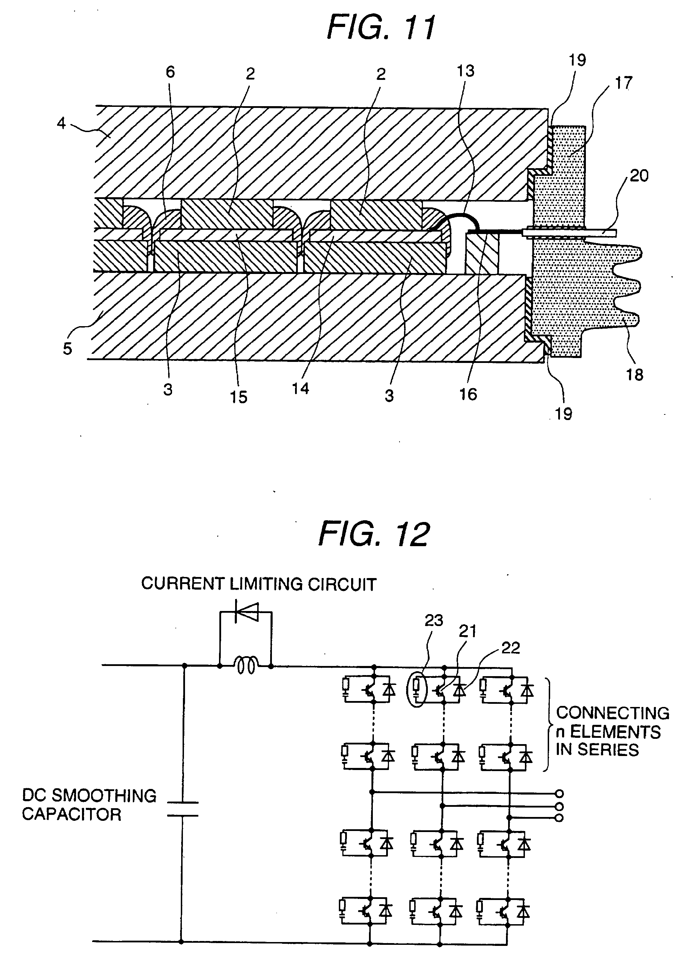

By using the flat type semiconductor device in accordance with the present invention, it is possible to manufacture a large capacity converter which can substantially reduce cost of the converter. FIG. 12 shows a configuration circuit of one bridge portion of an example of an electric power converter which the flat type semiconductor devices of IGBT in accordance with the embodiment of FIG. 1 to FIG. 4 are applied to as the main converter elements. The IGBT 21 used as the main converter element and a diode 22 are arranged in anti-parallel, and n elements of the anti-parallel circuits are connected in series. The IGBT 21 and the diode 22 are the flat type semiconductor device in accordance with the present invention which mounts many semiconductor chips in parallel. In the case of the embodiment of the reverse conducting IGBT flat type semiconductor device described above, the IGBT 21 and the diode 22 in the figure are contained in one package together. Snubber circuits 23 and a current limiting circuit are further arranged. FIG. 13 shows a self-exited converter which has a quadrupled construction of the three-phase bridges of FIG. 12. The flat type semiconductor devices of the present invention are mounted in a form called as a stack structure in which a plurality of flat type semiconductor devices connected in series interposing water cooling electrodes so as to face-contact with the out sides of the main electrode plates, and the whole stack is pressed in a lump.

In addition to the above, the flat type semiconductor device in accordance with the present invention is suitable particularly for a self-excitation large capacity converter used for an electric power system and a large capacity converter used as a mill converter, and can be also used for converters such as a variable speed pump-up generator, a in-building substation facility, a railway substation facility, a sodium-sulfur (NaS) battery system, an electric vehicle and so on.

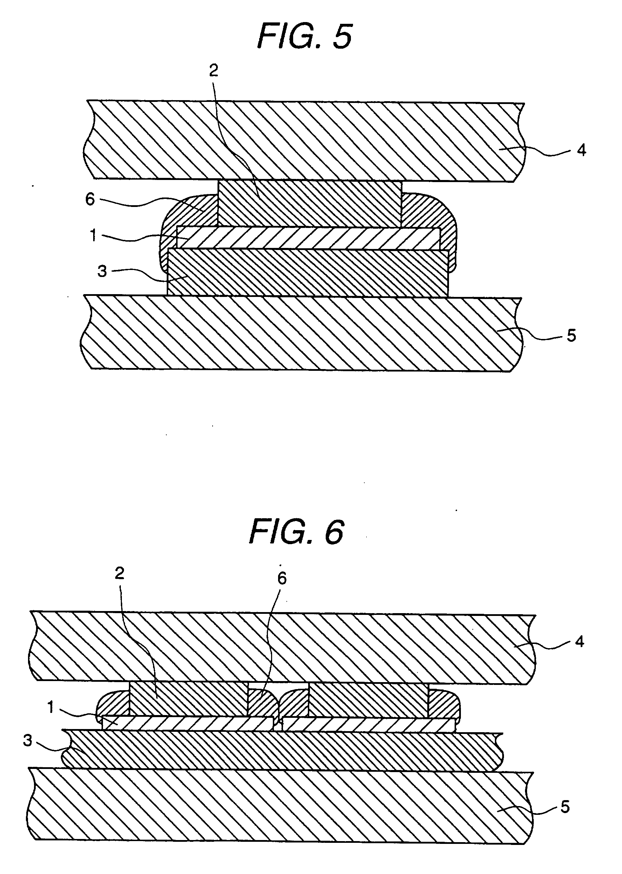

FIG. 5 shows an example of a semiconductor device which mounts a semiconductor element 1 between a pair of main electrode plates 4 and 5, and intermediate electrode plates 2 and 3 are individually inserted into gaps between two main electrodes of the semiconductor element 1 and the main electrode plates 4, 5 opposite to the two main electrodes, respectively. A first main electrode of aluminum electrode of the above-described semiconductor element 1 and the molybdenum intermediate electrode plate 2 having a silver plating layer on the surface in the first main electrode side are bonded each other through a bonding layer. Similarly, a second main electrode of aluminum electrode of the above-described semiconductor element 1 and the molybdenum intermediate electrode plate 3 having a silver plating layer on the surface in the second main electrode side are bonded each other through a bonding layer. Before setting the semiconductor element 1 and the intermediate electrode plates 2, 3 described above between the main electrode plates 4 and 5, a liquid silicone resin 6 is applied to the outer peripheral portion of the surface of the semiconductor element 1 not facing the intermediate electrode plate 2 and at least part of the side surface of the intermediate electrode plates 2 and 3 so as to seal the portions, and then heated to setting the resin at 150 °C. By doing so, a chip carrier structure (an assembly structure) composed of the semiconductor element 1 and the intermediate electrode plates 2, 3 is formed. Of course, the outer peripheral portion of the surfaces of the semiconductor element 1 not facing the intermediate electrode plate here includes the side surface of the semiconductor element.

The chip carrier structure (the assembly structure) composed of the semiconductor element 1 and the intermediate electrode plates 2, 3 sealed by the electric insulation material is a very simple and compact structure, and a low-cost insulation sealed type semiconductor device can be realized. It is preferable that the size in the surface direction of the chip carrier structure body is as compact as possible, and is nearly equal to the size of the semiconductor element. In more detail, it is preferable that an area in the maximum outer diameter of the carrier is below approximately 1.4 times of an area of the semiconductor element, that is, below approximately 1.2 times on the side dimensional basis. From the viewpoint of handling during manufacturing the semiconductor element 1 and protection from the external environment, it is also preferable that the semiconductor element is used in a form protected by the resin.

In FIG. 5, the intermediate electrode plates 2, 3 exposed to the surfaces of the chip carrier structure body are contained in the flat type semiconductor device so as to directly contact with the main electrode plates 4, 5. The direct contact is preferable to reduce the contact thermal resistance and the contact electric resistance as low as possible.

FIG. 6 shows an example of a chip carrier in which the side surface of the semiconductor element 1, the outer peripheral portion of the first main electrode surface of the semiconductor element 1 not facing the intermediate electrode plate 2 and at least part of the side surface of the intermediate electrode plate 2 interposed in the first main electrode side are sealed with a silicone denaturalized resin 6. The first main electrode of the semiconductor element 1 is bonded to the intermediate electrode plate 2 in the first main electrode side, and the second main electrode of the semiconductor element 1 is not bonded to the intermediate electrode plate 3 in the second main electrode side. Since the intermediate electrode plate. 3 in the present embodiment is used as the base plate common to the plurality of semiconductor elements 1, the chip carrier is constructed as described above. In the case of mounting a large number of the chip carriers described above, it is preferable to mount the chip carriers butting their side surfaces of the insulation material against one another without gaps.

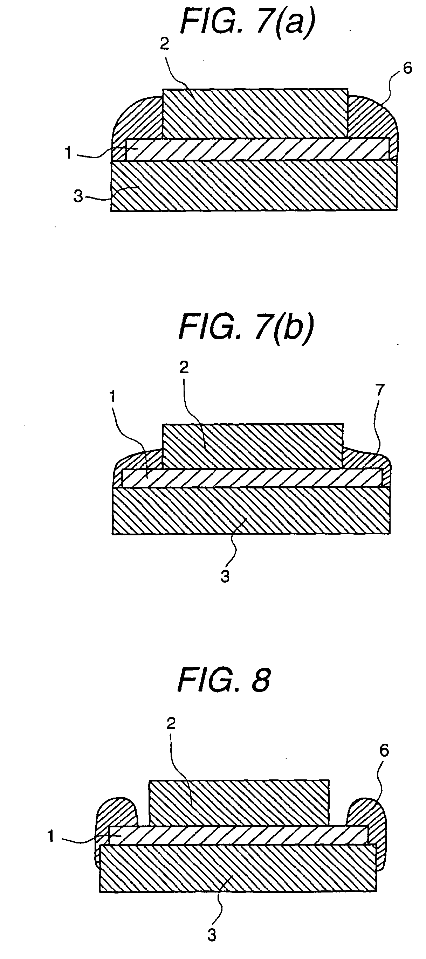

FIG. 7 (a), (b) show other examples of chip carriers in which the side surface of the semiconductor element 1, the outer peripheral portion of the first main electrode surface of the semiconductor element 1. not facing the intermediate electrode plate 2 and at least part of the side surface of the intermediate electrode plate 2 interposed in the first main electrode side are sealed with a silicone denaturalized resin 6, similarly to the chip carrier of FIG. 6, but the intermediate electrode plate 3 in the second main electrode side is individually divided for each of the semiconductor elements 1.

In FIG. 7 (a), the electric insulation material 6 is molded in the shape shown in the figure by injecting a slurry of kneading ceramic powder such as silica, zirconia, magnesia or the like with water into a mold, and by curing the slurry at room temperature after injection molding. The obtained ceramic sealed chip carrier is good in electric insulation and in heat resistance. In the example of FIG. 7 (b), the electric insulation material 6 is made of a material containing glass or crystallized glass as the major component. A glass coating film 7 is formed by applying a lead group glass (major component: PbO-SiO₂-Al₂O₃) in paste state onto the chip, and then by glass-sintering through heat treatment of 780 to 850 °C for 40 minutes under an oxygen atmosphere. It is preferable that the material is a glass having. a thermal expansion coefficient as close to that of the semiconductor element as possible and composition melted at a low temperature such as ZnO-B₂O₃-SiO₂ group glasses, PbO-Al₂O₃-SiO₂ group glasses, ZnO-B₂O₃-SiO₂ group crystallized glasses and so on. Further, it is preferable to use a glass containing alkali impurities as small as possible. Particularly, in a case where the semiconductor device is used under a severe condition requiring high environment resistance performance, it is preferable to employ an inorganic material having high hermetic sealing ability and high heat resistance.

FIG. 8 shows an example of a chip carrier in which the side surface of the semiconductor element 1, the outer peripheral portion of the first main electrode surface of the semiconductor element 1 not facing the intermediate electrode plate 2 and at least part of the side surface of the intermediate electrode plate 2 interposed in the first main electrode side are sealed with a silicone denaturalized resin 6. The first main electrode of the semiconductor element 1 is not bonded to the intermediate electrode plate 2 in the first main electrode side. This structure is characterized by that only the peripheral portion of the semiconductor element is insulated and sealed, that is, only the most important portion for securing insulation around the semiconductor element is sealed. Even by the..shape, the insulation reliability can be sufficiently secured without any problem.

However, since the semiconductor element surface in this case is not completely sealed, it is necessary that the insulation outer cylinder for externally insulating between the pair of main electrode plates exposed in the both surfaces of the flat type semiconductor device is formed of ceramics to hermetically seal the semiconductor element. Of course, it is possible that the carrier chip of the insulation material fully sealing type in accordance with the present invention is employed, and the hermetic seal is further performed by the insulation outer cylinder portion. In the case where hermetic seal is inevitable, an effective method is that at least part of the electric insulation outer cylinder for insulating and sealing between the pair of common main electrode plates exposed in the both surfaces is formed of a resin part, that is, that the electric insulation outer cylinder is formed of a combined structure of an inorganic material closed-packed insulation part and a resin part to hermetically seal the package by the inorganic material closed-packed insulation part and to sufficiently secure the distance along the external surface by the resin part portion. In other words, by separating a function of a material for hermetically sealing from a function of a material for sufficiently securing the distance along the insulating distance (the distance along the surface), both of high long term reliability and low cost can be attained. That is, the cost can be reduced by forming the complicated shaped part using the resin part easy in machining and in molding to sufficiently secure the external insulation distance of the semiconductor device.

As a concrete embodiment, for example, an outer cylinder ring made of polyphenylene-sulfide resin (anti-tracking ability above 600 V) pre-molded by injection molding was bonded onto an outer side portion of a simple cylindrical outer cylinder using a silicone bond. By doing so, the distance along the external surface could sufficiently secure the specified value, and it was checked from an accelerated endurance test that the semiconductor device had sufficient reliability. As an alternative method, an example in which the outer cylinder ring made of a resin described above is formed in a two-divided structure will be described below. The divided parts are formed so as to be coupled and engaged at their ends with each other. Number of divisions is not limited to two parts as in the present example, but the outer cylindrical ring may be divided into any number of parts so as to be easily assembled corresponding to shape of the ceramic outer cylindrical part to be combined.

In the complex insulation outer cylinder of the insulation outer cylindrical part made of ceramic or the like and the resin part described above, the complex insulation outer cylinder may be formed before mounting the element, or after mounting the element into and sealing the insulation outer cylindrical part, the resin portion may be formed through potting or fitting/bonding, as in the embodiment described above. Further, of course, the resin part may be formed so as to cover over all the surface of the ceramic part. Such a structure is preferable because it has an effect to prevent the ceramic part from being broken or chipped due to an impact at handling.

As a characteristic required for the resin group material, it is preferable that the tracking resistance (CTI value) is higher than 400 V, particularly preferable higher than 600 V. It is also preferable to use a resin material which has a flame retardancy of UL94V-0 level. Further, in regard to the thermal and mechanical properties, it is also preferable to use a resin material which is high in mechanical strength and in brittle rupture strength, and of which the thermal expansion coefficient can be adjusted to an optimum value determined by the other mounting materials and the mounting structure.

In the case where the resin part is combined and integrated with the electric insulation outer cylindrical part made of ceramic or the like, the resin material has a thermal expansion coefficient as near that of the ceramic group part as possible. As the concrete materials, it is preferable to. use a thermosetting resin of epoxy group, phenol group or the like, or an elastomer of silicone group, fluoride group. Further, a thermoplastic resin of engineering plastic group such as polyphnylene sulfide (PPS), aromatic polyamide, thermoplastic polyimide or the like may be used. Furthermore, a composite material mixing various kinds of filler to these material may be used. Since the insulation outer cylinder is a resin part, the shape along the external surface can be comparatively freely designed compared to the conventional ceramic part. Therefore, there is an advantage in that limitation in the design for securing the distance along external surface can be reduced.

As the method of manufacturing the resin part, in addition to the potting method described in the above example, injection molding, transfer molding, compression molding, powder sintering methods may be used, and an optimum method may be selected depending on the material and the mounting method. Particularly, in the case where the resin part is molded to be integrated directly with the ceramic outer cylinder through potting method, it is preferable to use silicone resin, urethane resin, polystyrene resin, polybutadiene resin, or an elastomer composed of copolymer of these resins, or a thermosetting material such as epoxy resin, phenol resin. In the case where the pre-molded resin part is bonded to be integrated with the electric insulation outer cylinder part or the electrode material made of ceramics or the like, it is preferable to use a silicone group, a fluoride group or an epoxy group rubber because the stress between materials to be bonded can be released by the rubber.

As the materials of the electric insulation part used for hermetically sealing, it is preferable to use an ordinary porcelain such as feldspathic ordinary porcelain, cristobalite porcelain, alumina containing porcelain, alumina containing cristobalite porcelain or the like, or a material containing a major component of alumina, magnesia, beryllia, steatite, forsterite, cordierite, mullite, zircon, zirconia or the like, or a glass group material such as a glass ceramic, boro-silicate glass, quartz glass, high silicate glass or the like. In the case where the electric insulation outer part made of the above-mentioned inorganic material is bonded to the resin part, it is a method effective to increase the bonding strength with the resin part by forming the surface of the inorganic material electric insulation outer part in an uneven surface. In order to do so, it is effective that unevenness is intentionally formed on the surface by controlling the sintering condition of the inorganic material electric insulation outer part, or that the inorganic material electric insulation outer part is normally sintered, and then the surface is processed using a means such as sandblast, liquid horning, etching, chemical grinding, electro-grinding or the like.

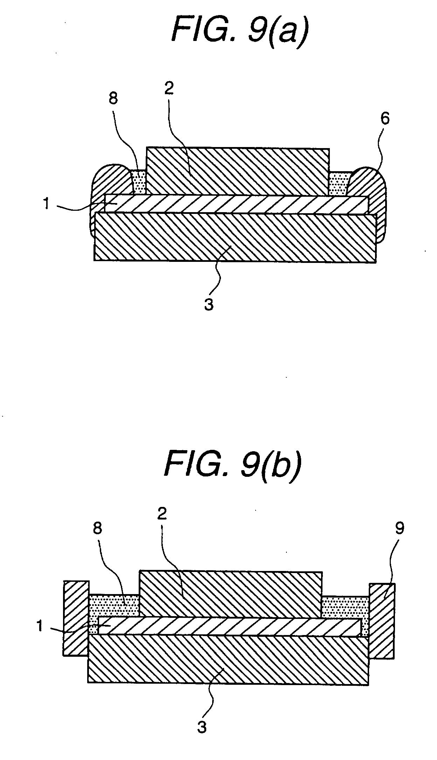

FIG. 9 (a) shows an embodiment of a double resin filling structure. In the structure, a first insulation seal material 6 is formed, and then a second insulation seal material 8 is filled. By employing materials different in physical property each other for the first insulation. seal material 6 and the second insulation seal material 8, it is possible to select a chip carrier structure capable of maintaining an optimum stress condition for a condition of using the semiconductor device. For example, by setting the Young modulus of the second insulation seal material to a value lower than that of the first insulation seal material, it is possible to select a combination in which the stress generated in the semiconductor element surface can be modulated, and the insulation ability and workability can be maintained by the second insulation seal material. In detail, silicone resin can be employed for the first insulation seal material, and silicone rubber or silicone gel can be employed fir the second insulation seal material. Since the gel cannot be molded by itself, an additional mold is necessary when the gel is used as the first insulation seal material. Therefore, it is not preferable from the viewpoints of cost reduction and workability that the gel is used for the first insulation seal material.

FIG. 9 (b) shows another embodiment of a double resin filling structure. In this embodiment, the first insulation seal material 9 (for example, an engineering plastic group resin) is mainly used as a mold for filling the second insulation seal material 8 (silicone resin), and directly used as part of the chip carrier. For example, by employing materials different in physical property each other for the first insulation seal material 9 and the second insulation seal material 8, a stable structure against a stress from the external to the chip carrier can be obtained.

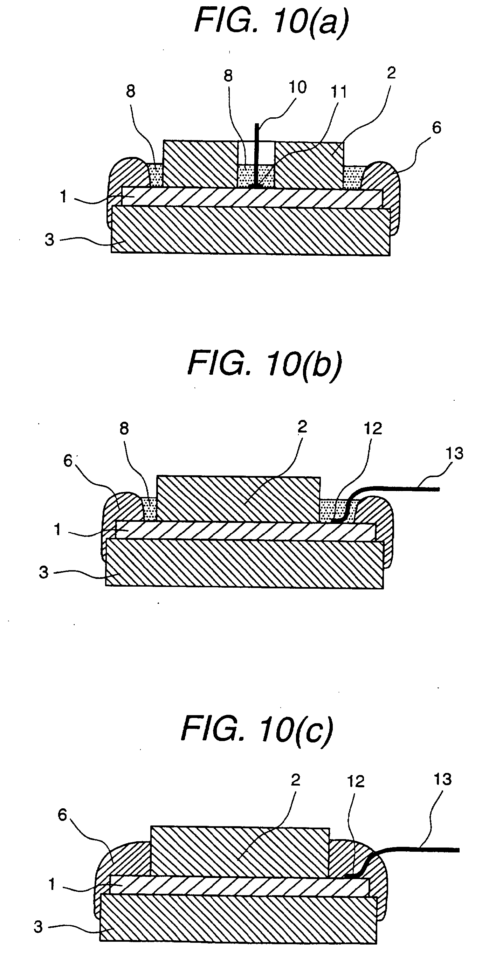

FIG. 10 shows embodiments of chip carriers each of which contains a semiconductor element having a first main electrode and a control electrode (a gate electrode) on the first main surface (FIG. 5 + FIG. 9 + a gate lead wire).

FIG. 10 (a) shows an embodiment in which a gate leading-out pin 10 is joined to the gate control electrode formed in the center of the semiconductor element 1. The gate leading-out pin 10 has a head 11 at the end in the chip side, the head 11 having a diameter lager than a diameter of the pin. The side surface of the semiconductor element 1, the outer peripheral portion of the first main electrode surface not in contact with the intermediate electrode plate 2 and at least part of the side surface of the intermediate electrode plate 3 in the second main electrode side are sealed by a first seal material 6 (phenol resin), and the remaining portions are filled with a second seal material 8 (silicone gel) to obtain a completely sealed chip carrier.

FIG. 10 (b) shows an embodiment in which the gate lead wire 13 is formed by wire bonding in the gate control electrode 12 formed in the peripheral portion of the semiconductor element 1. The side surface of the semiconductor element 1, the outer peripheral portion of the first main electrode surface not in contact with the intermediate electrode plate 2 and at least part of the side surface of the intermediate electrode plate 3 in the second main electrode side are sealed by a first seal material 8 (epoxy resin), and further the remaining portions are filled with a second seal material 8 (silicone rubber) to obtain a completely sealed chip carrier.

FIG. 10 (b) shows another embodiment in which the gate lead wire 13 is formed by wire bonding in the gate control electrode 12 formed in the peripheral portion of the semiconductor element 1. A composite material filling quartz powder to epoxy resin to decrease the thermal expansion is used for the insulation seal material. The side surface of the semiconductor element 1, the outer peripheral portion of the first main electrode surface not in contact with the intermediate electrode plate 2 and at least part of the side surfaces of the intermediate electrode plates 2, 3 and further the wire leading-out portion are uniformly sealed by the above-described composite resin to obtain a completely sealed chip carrier.

Electric insulation resins such as epoxy resin, phenol resin and polyester resin are suitable for the organic material group seal resins, and thermosetting resins having composition gradually curing by heating are preferable. An epoxy based resin is particularly suitable, and can be added with a hardening agent, a catalyst, a pigment, a filler and an additive for improving and/or maintaining the property, if necessary. Particularly, by using a low thermal expansion inorganic material powder such as, for example, crystallized and molten silica powder, alumina powder and the like as the filler, the thermal expansion coefficient of the composite material of resin and the above-mentioned powder can be made close to the thermal expansion coefficient of the semiconductor chip or the intermediate electrode plate. Therefore, the composite material can improve the reliability against thermal cycle. In general, it is preferable that the filler is contained above 60 % to the total resin composition, and particularly, it is preferable that the content of the filler is set within a range of 7 to 9 weight %. Further, it is possible that the water absorption ratio can be reduced and the resin strength can be improved by filling the inorganic filler up to a high density. Furthermore, the epoxy resin composite material used in the present invention may be added with silicone oil and a rubber component such as silicone rubber, synthetic rubber in order to reduce stress, or may be added with an ion trap agent such as hydrotarsite in order to improve the reliability of moisture resistance.

An optimum resin or an optimum composite resin can.be selected to requirements in regard to fluidity, low temperature curing property, defoaming property, low thixotropy, improvement of workability such as easiness of detaching from a mold when resin is molded using the mold, low thermal expansion, low content of impurity ions. Further, it is also possible that the stress is lowered by using silicone rubber, denaturalized silicone resin to improve the thermal impact resistance.

Of course, a thermoplastic resin can be used, and the usable materials are thermoplastic polyimide, aromatic polyamide, polyamide-imde resin, polyether-etherketone (PEEK), PPO, PPS, liquid crystal polymer. However, it is necessary these are melted to be injected and carefully handled.

In addition to the thermoplastic resin, an ultraviolet ray curable resin or an active energy beam curable resin, which is hardened by an active energy beam, such as an electron beam curable resin may be used depending on the uses of semiconductor device, the condition of manufacturing process and so on. Typical compositions of the active energy beam curable resins are alkyd resin, acrylic resin, urethane resin, polyurethane resin and epoxy resin having unsaturated radicals such as acrylic acid radical, allyl radical, itaconic acid radical, conjugated double bond and so on.

Sealing of the semiconductor element using organic resin compositions is not particularly limited, and can be performed through well known molding methods such as ordinary transfer molding. Further, in order to decrease size and thickness, to save process work and to reduce processes, there is a method in which a semiconductor element is mounted on and bonded to an intermediate electrode plate, and then resin is dropped down to coat the semiconductor element. In order to improve the workability, it is preferable that the thermoplastic resin is applied to an appropriate position using an automatic dispenser or the like, and then the resin is thermally hardened. Further, better sealing without foams can be performed by injecting a liquid seal resin into a mold for sealing work under a condition of setting the semiconductor element and the intermediate electrode plate inside the mold, and then by performing vacuum defoaming.

FIG. 11 shows an embodiment of a reverse conducting switching device containing switching devices using IGBTs and anti-parallel connected flywheel diodes (FWDs) to which the present invention is applied. The figure shows only part of the section of the flat type semiconductor device from the outermost periphery to a middle portion toward the center. In the IGBT chip 14, an emitter electrode is formed on nearly the whole surface of a first main surface in the upper surface side, and a collector electrode is formed on a second main surface in the lower surface side. Further, a control electrode (a gate electrode) is formed on the first main surface. In the FWD chip 15, an anode electrode is formed on the upper surface side of a silicon substrate, and a cathode electrode is formed on the lower surface side. In each of the semiconductor chips, intermediate electrodes 2, 3 made of molybdenum for serving. heat dissipation and electric connection are individually fixed to and contacted with the main electrodes on the chip, and each of the chips in contact with the intermediate electrodes is further put between a first main electrode plate 4 (Cu) and a second common main electrode plate 5 (Cu). A wire 13 is led out using a wire bond from a gate electrode of the IGBT chip 14, and is further connected to a gate electrode wire 16 formed on the main electrode 5. The semiconductor chips 14, 15 and the intermediate electrode plates 2, 3 are sealed. by silicone resin.

FIG. 11 shows an example in which the insulation outer cylinder is of a non-hermetic structure using resin, that is, the pair of outer main electrode plates 4, 5 are externally insulated between them and sealed by the outer cylinder 17 made of organic polyamide. The gaps between the outer main electrode plates 4, 5 and the insulation outer cylinder 17 are bonded and sealed by an organic bond 19. Further, a metal wire 20 fixed to the insulation outer cylinder 17 by a bond is formed, and the gate electrode wire 16 is led out of the package by the metal wire 20. The seal structure of the bonding portion 19 in the present embodiment is preferable because the bonded portion is always pressed in the direction strengthening the sealing when the semiconductor device is pressed while being used. It is preferable that a bond having a large elastic deformativity is used for the bond because it can respond to change in the distance between the main electrodes at being pressed and to deformation during being used. The distance along surface could be easily made very larger by making projections and depressions in the outer portion larger compared to a conventional ceramic part. Further, the semiconductor device having high reliability of impact resistance because the insulation outer cylinder made of resin is not as brittle as the ceramic outer cylinder against impact.

The method of the present invention can be applied both to a flat type semiconductor device in which many semiconductor elements are arranged in parallel between a pair of main electrode plates, and to a flat type semiconductor device in which semiconductor elements are constructed of one sheet of semiconductor element wafer having at least one p-n junction. Of course, in addition to the above, the method of the present invention can be applied both to a flat type semiconductor device which is composed of only switching elements such as IGBTs or the like and not contains any diodes, and to a flat type diode device in which a large number of only diodes are contained in a flat type package. The present invention relates to all kinds of the semiconductor elements that have at least a first main electrode on the first main surface and a second main electrode on the second main surface, and can be applied to an insulated gate transistor (MOS transistor) other than the IGBT; to a semiconductor element with a control electrode such as an insulated gate thyristor (MOS controlled thyristor) including an IGCT (insulated gate controlled thyristor), a GTO thyristor, a GCT thyristor, an optical thyristor, a thyristor; and to a diode without control electrode. Similarly, the present invention is effective to a semiconductor device in which a chemical compound semiconductor element such as SiC, GaN other than the Si element is used, and to a new environment (for example, a high temperature environment) using the semiconductor device.

By using the flat type semiconductor device in accordance with the present invention, it is possible to manufacture a large capacity converter which can substantially reduce cost of the converter. An electric power converter to which the flat type semiconductor devices of IGBT in accordance with the embodiments of FIG. 5 to FIG. 11 are applied as the main converter elements is shown in FIG. 12 previously described. The IGBT 21 used as the main converter element and a diode 22 are arranged in anti-parallel, and n elements of the anti-parallel circuits are connected in series. The IGBT 21 and the diode 22 are the flat type semiconductor device in accordance with the present invention which mounts many semiconductor chips in parallel. In the case of the embodiment of the reverse conducting IGBT flat type semiconductor device described above, the IGBT 21 and the diode 22 in the figure are contained in one package together. Snubber circuits 23 and a current limiting circuit are further arranged. FIG. 13, described previously, shows a self-exited converter which has a quadrupled construction of the three-phase bridges. The flat type semiconductor devices of the present invention are mounted in a form called as a stack structure in which a plurality of flat type semiconductor devices connected in series interposing water cooling electrodes so as to face-contact with the out sides of the main electrode plates, and the whole stack is pressed in a lump.

According to the present invention, insulation reliability of the flat type semiconductor device can be improved. Further, according to the present invention, by the carrier structure (the assembly structure) of the semiconductor element and the intermediate electrode plates sealed by the insulation material, the size on mounting unit can be reduced and the mounting density can be improved. Furthermore, workability (handling ability) at assembling is improved, and repairing on chip carrier unit bases also becomes very easy. The stability is improved from the viewpoint of protection from the external environment during processing and after manufacturing. Therefore, the flat type semiconductor device in accordance with the present invention can reduce the part cost and the assembling cost as a semiconductor device, and can improve the manufacturing yield while the reliability is being kept high. Further, by changing the material forming the outer cylinder part for externally insulating the pair of main electrode plates from the conventional ceramics to the economical resin, the cost can be further decreased.

By using the flat type semiconductor device in accordance with the present invention having the above-mentioned characteristics, cost of the converter system can be reduced.

## Claims

1. A flat type semiconductor device containing at least one semiconductor element in a flat type package in which an insulating outer cylinder insulates and seals between a pair of common main electrode plates exposing to both surfaces of said flat type semiconductor device, said semiconductor element having a first main electrode on a first main surface and a second main electrode on a second main surface, wherein at least a part of said insulating outer cylinder is formed of a resin part.

2. A flat type semiconductor device according to claim 1, wherein said insulating outer cylinder is formed of a combined structure of an inorganic material part and said resin part, and the inside of said package is hermetically sealed.

3. A flat type semiconductor device according to any one of claim 1 and claim 2, wherein said resin part increases a distance between said pair of common main electrode plates exposing to the both surface of the flat type semiconductor device along an external surface of the semiconductor device to a value larger than a spatial distance between said pair of common main electrode plates.

4. A flat type semiconductor device according to claim 1, which comprises a structure that at least part of bond for bonding said common main electrode plates and said resin part is pressed against displacement between said common main electrode plates.

5. An electric power converter using flat type semiconductor devices as main converting element, said flat type semiconductor device containing at least one semiconductor element in a flat type package in which an insulating outer cylinder insulates and seals between a pair of common main electrode plates exposing to both surfaces of said flat type semiconductor device, said semiconductor element having a first main electrode on a first main surface and a second main electrode on a second main surface, wherein at least a part of said insulating outer cylinder is formed of a resin part.

6. A flat type semiconductor device containing at least one semiconductor element in a flat type package in which an insulating outer cylinder insulates externally between a pair of common main electrode plates exposing to both surfaces of said flat type semiconductor device, said. semiconductor element having a first main electrode on a first main surface and a second main electrode on a second main surface, wherein individual intermediate electrode plates are inserted into gaps between two main electrodes of said semiconductor element and said main electrode plates respectively opposite to said main electrodes for each of said semiconductor elements, and an outer peripheral portion not facing said intermediate electrode plates among surfaces of said semiconductor element and at least part of side surface of said intermediate electrode plate are sealed by an electric insulation material.

7. A flat type semiconductor device containing at least one semiconductor element in a flat type package in which an insulating outer cylinder insulates externally between a pair of common main electrode plates exposing to both surfaces of said flat type semiconductor device, said semiconductor element having a first main electrode on a first main surface and a second main electrode on a second main surface, wherein individual intermediate electrode plates are inserted into at least a gap in the first main electrode side between the gaps between main electrodes of said semiconductor element and said main electrode plates respectively opposite to said main electrodes, and an side surface of said semiconductor element, an outer peripheral portion not facing said intermediate electrode plates among surfaces. of the first main electrode of said semiconductor element and at least part of a side surface of said intermediate electrode plate inserted into the gap of the first main electrode side are sealed by an electric insulation material.

8. A flat type semiconductor device containing at least one semiconductor element in a flat type package in which an insulating outer cylinder insulates externally between a pair of common main electrode plates exposing to both surfaces of said flat type semiconductor device, said semiconductor element having a first main electrode on a first main surface and a second main electrode on a second main surface, wherein individual intermediate electrode plates are inserted into gaps between two main electrodes of said semiconductor element and said main electrode plates respectively opposite to said main electrodes for each of said semiconductor elements, and an side surface of said semiconductor element, an outer peripheral portion not facing said intermediate electrode plates among surfaces of the first main electrode of said semiconductor element and at least part of a side surface of said intermediate electrode plate inserted into the gap of the second main electrode side are sealed by an electric insulation material.

9. A flat type semiconductor device according to any one of claims 1 to 3, wherein at least the second main electrode between the main electrodes of said semiconductor element is joined to an intermediate electrode plate opposite to said main electrode.

10. A flat type semiconductor device according to any one of claims 1 to 4, wherein at least the first main electrode between the main electrodes of said semiconductor element is joined to an intermediate electrode plate opposite to said main electrode.

11. A flat type semiconductor device according to any one of claims 1 to 5, wherein said electric insulation material is a material having moldability.

12. A flat type semiconductor device according to any one of claims 1 to 6, wherein said electric insulation material is a material of which a major component is a thermosetting or a thermoplastic resin.

13. A flat type semiconductor device according to any one of claims 1 to 7, wherein said electric insulation material is a composite material of a thermosetting resin and an inorganic material powder.

14. A flat type semiconductor device according to any one of claims 1 to 6, wherein said electric insulation material is a material of which a major component is glass or ceramics.

15. A flat type semiconductor device according to any one of claims 1 to 9, wherein size in a surface direction of a structural body sealed by said electric insulation material and integrated with said semiconductor element and said intermediate electrode plate is nearly equal to size of said semiconductor element.

16. An electric power converter using flat type semiconductor devices as main converting element, said flat type semiconductor device containing at least one semiconductor element in a flat type package in which an insulating outer cylinder insulates externally between a pair of common main electrode plates exposing to both surfaces of said flat type semiconductor device, said semiconductor element having a first main electrode on a first main surface and a second main electrode on a second main surface, wherein individual intermediate electrode plates are inserted into gaps between two main electrodes of said semiconductor element and said main electrode plates respectively opposite to said main electrodes for each of said semiconductor elements, and an outer peripheral portion not facing said intermediate electrode plates among surfaces of said semiconductor element and at least part of side surface of said intermediate electrode plate are sealed by an electric insulation material.

17. An electric power converter using flat type semiconductor devices as main converting element, said flat type semiconductor device containing at least one semiconductor element in a flat type package in which an insulating outer cylinder insulates externally between a pair of common main electrode plates exposing to both surfaces of said flat type semiconductor device, said semiconductor element having a first main electrode on a first main surface and a second main electrode on a second main surface, wherein individual intermediate electrode plates are inserted into at least a gap in the first main electrode side between the gaps between main electrodes of said semiconductor element and said main electrode plates respectively opposite to said main electrodes, and an side surface of said semiconductor element, an outer peripheral portion not facing said intermediate electrode plates among surfaces of the first main electrode of said semiconductor element and at least part of a side surface of said intermediate electrode plate inserted into the gap of the first main electrode side are sealed by an electric insulation material.

18. An electric power converter using flat type semiconductor devices as main converting element, said flat type semiconductor device containing at least one semiconductor element in a flat type package in which an insulating outer cylinder insulates externally between a pair of common main electrode plates exposing to both surfaces of said flat type semiconductor device, said semiconductor element having a first main electrode on a first main surface and a second main electrode on a second main surface, wherein individual intermediate electrode plates are inserted into gaps between two main electrodes of said semiconductor element and said main electrode plates respectively opposite to said main electrodes for each of said semiconductor elements, and an side surface of said semiconductor element, an outer peripheral portion not facing said intermediate electrode plates among surfaces of the first main electrode of said semiconductor element and at least part of a side surface of said intermediate electrode plate inserted into the gap of the second main electrode side are sealed by an electric insulation material.
